# EUROPEAN PATENT APPLICATION

(11) **EP 4 757 563 A1**
(43) Date of publication of application: **10.06.2026**
(21) Application number: 25215469.5
(22) Date of filing: 13.11.2025
(51) Int. Cl.: H10N 30/853, H10N 30/50, H10N 30/20, H10N 30/00, B41J 2/14

(54) **PIEZOELECTRIC ELEMENT, LIQUID EJECTION HEAD, AND LIQUID EJECTION APPARATUS**

(30) Priority: 15.11.2024 JP 2024199674
(71) Applicant: Seiko Epson Corporation, Tokyo 160-8801 (JP)
(72) Inventor: YANO, Yoshiki, Suwa-shi, 392-8502 (JP); OKADA, Shu, Suwa-shi, 392-8502 (JP); HAMADA, Yasuaki, Suwa-shi, 392-8502 (JP); ASAKAWA, Tsutomu, Suwa-shi, 392-8502 (JP)
(74) Representative: Lewis Silkin LLP

(57) **Abstract**

A piezoelectric element includes a substrate, a first electrode disposed on the substrate, a piezoelectric layer disposed on the first electrode and containing potassium, sodium, and niobium, and a second electrode disposed on the piezoelectric layer, wherein the piezoelectric layer includes a first layer disposed on the first electrode, and a second layer disposed on the first layer, the piezoelectric layer includes a first region including a first interface between the first layer and the second layer, and a second region located inside the first layer without including the first interface, and a molar ratio of potassium to sodium in the first region is higher than the molar ratio in the second region.

## Description

The present application is based on, and claims priority from JP Application Serial Number 2024-199674, filed November 15, 2024, the disclosure of which is hereby incorporated by reference herein in its entirety.

### BACKGROUND

### 1. Technical Field

The present disclosure relates to a piezoelectric element, a liquid ejection head, and a liquid ejection apparatus.

### 2. Related Art

A piezoelectric element used in a liquid ejection head or the like of an inkjet printer is configured by, for example, sandwiching, with two electrodes, a piezoelectric layer made of a piezoelectric material having an electromechanical conversion function.

A piezoelectric laminated body including a piezoelectric film using potassium sodium niobate (KNN) formed by a sputtering method is described in, for example, JP-A-2023-30638.

JP-A-2023-30638 is an example of the related art.

It is known that the piezoelectric film using KNN described above is likely to generate a leakage current. Therefore, in order to reduce the leakage current, it is desired to improve the insulation property of the piezoelectric film.

### SUMMARY

An aspect of a piezoelectric element according to the present disclosure includes
a substrate,
a first electrode disposed on the substrate,
a piezoelectric layer disposed on the first electrode and containing potassium, sodium, and niobium, and
a second electrode disposed on the piezoelectric layer, wherein
the piezoelectric layer includes
a first layer disposed on the first electrode, and
a second layer disposed on the first layer,
the piezoelectric layer includes
a first region including a first interface between the first layer and the second layer, and
a second region located inside the first layer without including the first interface, and
a molar ratio of potassium to sodium in the first region is higher than the molar ratio in the second region.

An aspect of a liquid ejection head according to the present disclosure includes
the piezoelectric element.

An aspect of the liquid ejection apparatus according to the present disclosure includes the liquid ejection head.

### BRIEF DESCRIPTION OF THE DRAWINGS

FIG. 1 is a cross-sectional view schematically showing a piezoelectric element according to an embodiment.
FIG. 2 is a cross-sectional view schematically showing the piezoelectric element according to the present embodiment.
FIG. 3 is an exploded perspective view schematically showing a liquid ejection head according to the present embodiment.
FIG. 4 is a plan view schematically showing the liquid ejection head according to the present embodiment.
FIG. 5 is a cross-sectional view schematically showing the liquid ejection head according to the present embodiment.
FIG. 6 is a perspective view schematically showing a liquid ejection apparatus according to the present embodiment.
FIG. 7 is a diagram showing graphs representing results of an SIMS analysis in Practical Examples 1 and 2.
FIG. 8 is a diagram showing graphs representing a result of the SIMS analysis in Comparative Example 1.
FIG. 9 is a diagram showing a graph representing a result of the SIMS analysis in Practical Example 3.

### DESCRIPTION OF EMBODIMENTS

A preferred embodiment of the present disclosure will hereinafter be described in detail with reference to the drawings. Note that the embodiment to be described below does not unreasonably limit the present disclosure set forth in the appended claims. Further, it is not necessarily true that all the configurations to be described below are essential elements of the present disclosure.

### 1. Piezoelectric Element

### 1.1. Configuration

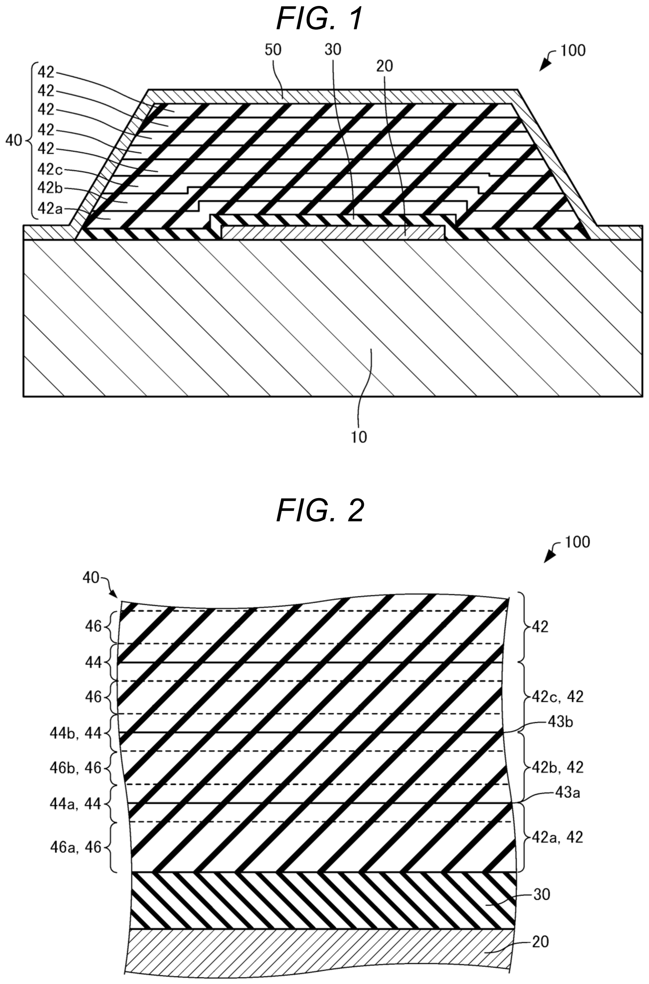

First, a piezoelectric element according to the present embodiment will be described with reference to the drawings. FIG. 1 is a cross-sectional view schematically showing a piezoelectric element 100 according to the present embodiment.

As illustrated in FIG. 1, the piezoelectric element 100 includes, for example, a substrate 10, a first electrode 20, an orientation control layer 30, a piezoelectric layer 40, and a second electrode 50.

The substrate 10 is a flat plate formed of, for example, a semiconductor or an insulator. The substrate 10 may be a single layer or may be a laminated body having a plurality of layers stacked on one another. An internal structure of the substrate 10 is not limited as long as an upper surface has a planar shape, and may have a structure in which a space or the like is formed inside.

The substrate 10 may include a vibrating plate that is deformed by an action of the piezoelectric layer 40. The vibrating plate is, for example, a laminated body in which a zirconium oxide layer is disposed on a silicon oxide layer, a zirconium oxide layer, or a silicon oxide layer.

Note that in the description related to the present disclosure, a term "on" is used as, for example, "a specific object (hereinafter referred to as "B") is formed "on" another specific object (hereinafter referred to as "A")." In the description related to the present disclosure, in such a case as this example, the term "on" is used to include when B is formed directly on A and when B is formed on A via another object.

The first electrode 20 is disposed on the substrate 10. The first electrode 20 is disposed between the substrate 10 and the orientation control layer 30. The shape of the first electrode 20 is a layered shape. The thickness of the first electrode 20 is, for example, 5 nm or more and 300 nm or less, and preferably 50 nm or more and 200 nm or less.

The first electrode 20 is, for example, a titanium layer, a platinum layer, or an iridium layer. The first electrode 20 may be a laminated body in which a titanium layer, a platinum layer, and an iridium layer are stacked in this order from the substrate 10 side. The titanium layer increases, for example, adhesion between the substrate 10 and the platinum layer. The first electrode 20 may include a titanium oxide layer instead of the titanium layer. The first electrode 20 is one of electrodes for applying a voltage to the piezoelectric layer 40. The first electrode 20 is, for example, a lower electrode disposed at a lower side of the piezoelectric layer 40.

The orientation control layer 30 is disposed on the first electrode 20. The orientation control layer 30 is disposed between the first electrode 20 and the piezoelectric layer 40. In the illustrated example, the orientation control layer 30 is further disposed on the substrate 10. The thickness of the orientation control layer 30 is, for example, 5 nm or more and 30 nm or less, and preferably 10 nm or more and 25 nm or less. The orientation control layer 30 contains, for example, a complex oxide having a perovskite-type structure containing bismuth (Bi), iron (Fe), titanium (Ti), and lead (Pb). The orientation control layer 30 is, for example, a bismuth ferrite lead titanate ((Bi, Pb)(Fe, Ti)O₃:BFTP) layer. The orientation control layer 30 may be a BFTP layer with an additive. The orientation control layer 30 controls the orientation of the piezoelectric layer 40. Specifically, the orientation control layer 30 orients the piezoelectric layer 40 on the (100) plane.

The piezoelectric layer 40 is disposed on the orientation control layer 30. The piezoelectric layer 40 is disposed on the first electrode 20 via the orientation control layer 30. The piezoelectric layer 40 is disposed between the orientation control layer 30 and the second electrode 50. The thickness of the piezoelectric layer 40 is, for example, 100 nm or more and 3000 nm or less, and preferably 500 nm or more and 2000 nm or less. The piezoelectric layer 40 is deformed by applying a voltage between the first electrode 20 and the second electrode 50.

The piezoelectric layer 40 contains, for example, a complex oxide having a perovskite-type structure containing potassium (K), sodium (Na), and niobium (Nb). The piezoelectric layer 40 is a potassium sodium niobate ((K,Na)NbO₃:KNN) layer. A composition of the perovskite-type structure of the piezoelectric layer 40 may be a stoichiometric composition or may be different from the stoichiometric composition. The same applies to the orientation control layer 30. The piezoelectric layer 40 may be a KNN layer with an additive. Examples of the additive include lithium (Li), manganese (Mn), and copper (Cu). Such an additive can reduce the leakage current of the piezoelectric layer 40.

The piezoelectric layer 40 includes a plurality of crystal layers 42. The piezoelectric layer 40 is formed of, for example, the plurality of crystal layers 42. The number of crystal layers 42 is, for example, 2 or more and 20 or less, preferably 3 or more and 15 or less. In the illustrated example, eight crystal layers 42 are provided. The thickness of the crystal layer 42 is, for example, 10 nm or more and 300 nm or less, and preferably 50 nm or more and 200 nm or less. In the plurality of crystal layers 42, the thicknesses of the crystal layers 42 may be the same as each other or may be different from each other.

Out of the plurality of crystal layers 42 of the piezoelectric layer 40, a first crystal layer 42a is disposed on the orientation control layer 30, a second crystal layer 42b is disposed on the first crystal layer 42a, and a third crystal layer 42c is disposed on the second crystal layer 42b. The first crystal layer 42a is disposed on the first electrode 20 via the orientation control layer 30. The first crystal layer 42a is disposed between the orientation control layer 30 and the second crystal layer 42b. The first crystal layer 42a is in contact with the orientation control layer 30. The second crystal layer 42b is disposed between the first crystal layer 42a and the third crystal layer 42c. The second crystal layer 42b is in contact with the first crystal layer 42a. The third crystal layer 42c is in contact with the second crystal layer 42b.

Here, FIG. 2 is a cross-sectional view schematically showing the piezoelectric element 100, and is an enlarged view of the vicinity of the first crystal layer 42a in FIG. 1.

As shown in FIG. 2, the piezoelectric layer 40 has, for example, a plurality of K-rich regions 44 and a plurality of Na-rich regions 46. The K-rich region 44 includes an interface between the crystal layers 42 adjacent to each other. The Na-rich region 46 does not include the interface between the crystal layers 42 adjacent to each other. In the illustrated example, the Na-rich region 46 includes a middle point in the thickness direction of the piezoelectric layer 40 between the interfaces of the crystal layers 42 adjacent to each other. The K-rich regions 44 and the Na-rich regions 46 are alternately disposed in, for example, the thickness direction of the piezoelectric layer 40. Note that the "thickness direction of the piezoelectric layer 40" is a stacking direction of the plurality of crystal layers 42 and is a depth direction of the piezoelectric layer 40.

The molar ratio of potassium to sodium (hereinafter also referred to as "K/Na molar ratio") in the K-rich region 44 is higher than the K/Na molar ratio in the Na-rich region 46. In the K-rich region 44, for example, the atomic concentration (at%) of potassium is higher than the atomic concentration (at%) of sodium. In the K-rich region 44, for example, the molar number of potassium is larger than the molar number of sodium. In the Na-rich region 46, for example, the atomic concentration (at%) of potassium is lower than the atomic concentration (at%) of sodium. The K/Na molar ratio and the atomic concentration (at%) of each element are measured by, for example, secondary ion mass spectrometry (SIMS) analysis or energy dispersive X-ray spectroscopy (EDS) analysis.

A first K-rich region 44a out of the plurality of K-rich regions 44 includes a first interface 43a between the first crystal layer 42a and the second crystal layer 42b. A first Na-rich region 46a out of the plurality of Na-rich regions 46 is located inside the first crystal layer 42a without including the first interface 43a between the first crystal layer 42a and the second crystal layer 42b. The first Na-rich region 46a is located between the orientation control layer 30 and the first K-rich region 44a. In the illustrated example, the first Na-rich region 46a is in contact with the orientation control layer 30.

A second K-rich region 44b out of the plurality of K-rich regions 44 includes a second interface 43b between the second crystal layer 42b and the third crystal layer 42c. A second Na-rich region 46b out of the plurality of Na-rich regions 46 is located inside the second crystal layer 42b without including the second interface 43b between the second crystal layer 42b and the third crystal layer 42c.

The atomic concentration (at%) of niobium in the K-rich region 44 is higher than, for example, the atomic concentration (at%) of niobium in the Na-rich region 46. A difference between the atomic concentration (at%) of niobium in the K-rich region 44 and the atomic concentration (at%) of niobium in the Na-rich region 46 is smaller than, for example, a difference between the atomic concentration (at%) of potassium in the K-rich region 44 and the atomic concentration (at%) of potassium in the Na-rich region 46. Further, the difference between the atomic concentration (at%) of niobium in the K-rich region 44 and the atomic concentration (at%) of niobium in the Na-rich region 46 is smaller than, for example, a difference between the atomic concentration (at%) of sodium in the K-rich region 44 and the atomic concentration (at%) of sodium in the Na-rich region 46.

The atomic concentration (at%) of manganese in the K-rich region 44 is higher than, for example, the atomic concentration (at%) of manganese in the Na-rich region 46. The atomic concentration (at%) of copper in the K-rich region 44 is higher than, for example, the atomic concentration (at%) of copper in the Na-rich region 46. The atomic concentration (at%) of lithium in the Na-rich region 46 is higher than, for example, the atomic concentration (at%) of lithium in the K-rich region 44.

As shown in FIG. 1, the second electrode 50 is disposed on the piezoelectric layer 40. In the illustrated example, the second electrode 50 covers an upper surface and a side surface of the piezoelectric layer 40 and is disposed on the substrate 10. The shape of the second electrode 50 is a layered shape. The thickness of the second electrode 50 is, for example, 5 nm or more and 300 nm or less, and preferably 30 nm or more and 200 nm or less.

The second electrode 50 is, for example, a platinum layer, a titanium layer, an iridium layer, or a laminated body thereof. The second electrode 50 is another of the electrodes for applying the voltage to the piezoelectric layer 40. The second electrode 50 is, for example, an upper electrode disposed at an upper side of the piezoelectric layer 40.

### 1.2. Functions and Advantages

The piezoelectric element 100 includes the substrate 10, the first electrode 20 disposed on the substrate 10, the piezoelectric layer 40 that is disposed on the first electrode 20 and contains potassium, sodium, and niobium, and the second electrode 50 disposed on the piezoelectric layer 40. The piezoelectric layer 40 includes the first crystal layer 42a as a first layer disposed on the first electrode 20 and the second crystal layer 42b as a second layer disposed on the first crystal layer 42a. The piezoelectric layer 40 includes the first K-rich region 44a as a first region including the first interface 43a between the first crystal layer 42a and the second crystal layer 42b, and the first Na-rich region 46a as a second region that does not include the first interface 43a and is located inside the first crystal layer 42a. The K/Na molar ratio in the first K-rich region 44a is higher than the K/Na molar ratio in the first Na-rich region 46a.

Therefore, in the piezoelectric element 100, since the first Na-rich region 46a is located at the first electrode 20 side, the first crystal layer 42a can be grown in the order of sodium niobate and potassium niobate from the first electrode 20 side using sodium niobate, which is easily crystallized, as a nucleus. Since sodium niobate (NaNbO₃) is lower in crystallization temperature than potassium niobate (KNbO₃) by about 100°C, crystal growth of the piezoelectric layer 40 can be promoted by growing the first crystal layer 42a using sodium niobate as a nucleus. Further, in the piezoelectric element 100, the insulation property of the piezoelectric layer 40 can be improved in the first K-rich region 44a having the high insulation property, and the leakage current can be reduced.

In the piezoelectric element 100, in the first K-rich region 44a, the atomic concentration (at%) of potassium is higher than the atomic concentration (at%) of sodium, and in the first Na-rich region 46a, the atomic concentration (at%) of potassium is lower than the atomic concentration (at%) of sodium. Therefore, in the piezoelectric element 100, the crystal growth of the piezoelectric layer 40 can be promoted, and the insulation property of the piezoelectric layer 40 can be improved.

In the piezoelectric element 100, the piezoelectric layer 40 includes the third crystal layer 42c as a third layer disposed on the second crystal layer 42b, the piezoelectric layer 40 includes the second K-rich region 44b as a third region including the second interface 43b between the second crystal layer 42b and the third crystal layer 42c, and the second Na-rich region 46b as a fourth region located inside the second crystal layer 42b without including the second interface 43b, and the K/Na molar ratio in the second K-rich region 44b is higher than the K/Na molar ratio in the second Na-rich region 46b. Therefore, in the piezoelectric element 100, the insulation property of the piezoelectric layer 40 can be further improved by the second K-rich region 44b.

In the piezoelectric element 100, the atomic concentration (at%) of niobium in the first K-rich region 44a is higher than the atomic concentration (at%) of niobium in the first Na-rich region 46a. Therefore, in the piezoelectric element 100, defects of niobium in the first K-rich region 44a can be reduced. Thus, the insulation property in the first K-rich region 44a can be effectively improved.

In the piezoelectric element 100, the difference between the atomic concentration (at%) of niobium in the first K-rich region 44a and the atomic concentration (at%) of niobium in the first Na-rich region 46a is smaller than the difference between the atomic concentration (at%) of potassium in the first K-rich region 44a and the atomic concentration (at%) of potassium in the first Na-rich region 46a and the difference between the atomic concentration (at%) of sodium in the first K-rich region 44a and the atomic concentration (at%) of sodium in the first Na-rich region 46a. Therefore, in the piezoelectric element 100, the composition gradient of niobium in the thickness direction of the piezoelectric layer 40 is flatter than those of potassium and sodium, and defects of niobium can be reduced in the entire piezoelectric layer 40. Accordingly, the insulation property of the piezoelectric layer 40 can be effectively improved.

In the piezoelectric element 100, the piezoelectric layer 40 contains manganese, and the atomic concentration (at%) of manganese in the first K-rich region 44a is higher than the atomic concentration (at%) of manganese in the first Na-rich region 46a. Therefore, in the piezoelectric element 100, a difference between the lattice constant of the first K-rich region 44a and the lattice constant of the first Na-rich region 46a can be reduced, and the lattice matching property can be improved. Accordingly, stress generated in the piezoelectric layer 40 can be reduced. As a result, a possibility that cracks occur in the piezoelectric layer 40 can be reduced.

In the piezoelectric element 100, the piezoelectric layer 40 contains copper, and the atomic concentration (at%) of copper in the first K-rich region 44a is higher than the atomic concentration (at%) of copper in the first Na-rich region 46a. Therefore, in the piezoelectric element 100, a difference between the lattice constant of the first K-rich region 44a and the lattice constant of the first Na-rich region 46a can be reduced, and the lattice matching property can be improved. Accordingly, stress generated in the piezoelectric layer 40 can be reduced. As a result, a possibility that cracks occur in the piezoelectric layer 40 can be reduced.

In the piezoelectric element 100, the piezoelectric layer 40 contains lithium, and the atomic concentration (at%) of lithium in the first Na-rich region 46a is higher than the atomic concentration (at%) of lithium in the first K-rich region 44a. Therefore, in the piezoelectric element 100, it becomes easy for sodium to partially be replaced with lithium in the first Na-rich region 46a, and the crystal growth of the piezoelectric layer 40 can be promoted.

The piezoelectric element 100 includes the orientation control layer 30 that is disposed between the first electrode 20 and the piezoelectric layer 40 and contains bismuth, iron, titanium, and lead, and the first Na-rich region 46a is located between the orientation control layer 30 and the first K-rich region 44a. Therefore, in the piezoelectric element 100, the lattice matching property between the piezoelectric layer 40 and the orientation control layer 30 can be improved. Accordingly, stress generated in the piezoelectric layer 40 can be reduced. As a result, a possibility that cracks occur in the piezoelectric layer 40 can be reduced.

### 2. Method of Manufacturing Piezoelectric Element

Then, a method of manufacturing the piezoelectric element 100 according to the present embodiment will be described with reference to the drawings.

As shown in FIG. 1, the substrate 10 is prepared. Specifically, a silicon oxide layer is formed by performing thermal oxidation of a silicon substrate. Then, a zirconium layer is formed on the silicon oxide layer using a sputtering method or the like, and then a zirconium oxide layer is formed by thermally oxidizing the zirconium layer. The substrate 10 can be prepared in the steps described above.

Then, the first electrode 20 is formed on the substrate 10. The first electrode 20 is formed by, for example, a sputtering method or a vacuum deposition method. Then, the first electrode 20 is patterned by, for example, photolithography and etching.

Then, the orientation control layer 30 is formed on the first electrode 20 and the substrate 10. The orientation control layer 30 is formed by, for example, a chemical solution deposition (CSD) method such as a sol-gel method or metal organic deposition (MOD).

Specifically, first, a precursor solution is prepared by dissolving or dispersing a metal complex containing bismuth, a metal complex containing iron, a metal complex containing titanium, and a metal complex containing lead in an organic solvent. Then, the precursor solution is applied onto the first electrode 20 and the substrate 10 by a spin coating method to form a precursor layer. Then, the precursor layer is heated at a temperature of, for example, 130°C or higher and 250°C or lower and dried for a certain period of time, and the precursor layer thus dried is further heated at a temperature of, for example, 300 °C or higher and 450 °C or lower and held for a certain period of time to thereby be degreased. Then, the precursor layer thus degreased is crystallized by firing at a temperature of, for example, 550 °C or higher and 800 °C or lower. In this way, the orientation control layer 30 formed of the BFTP layer can be formed.

Then, the piezoelectric layer 40 is formed on the orientation control layer 30. The piezoelectric layer 40 is formed by, for example, a CSD method. Hereinafter, when a KNN layer containing lithium, manganese, and copper as additives is formed as the piezoelectric layer 40 will be described.

First, the precursor solution is prepared by dissolving or dispersing a metal complex containing potassium, a metal complex containing sodium, a metal complex containing niobium, a metal complex containing lithium, a metal complex containing manganese, and a metal complex containing copper in an organic solvent.

Examples of the metal complex containing potassium include potassium 2-ethylhexanoate and potassium acetate. Examples of the metal complex containing sodium include sodium 2-ethylhexanoate and sodium acetate. Sodium 2-ethylhexanoate is stable, and is therefore easy to use as a raw material. Furthermore, sodium 2-ethylhexanoate has a low melting point, and an oxide thereof also has a low melting point, and is easy to use as a crystal nucleus. Examples of the metal complex containing niobium include niobium 2-ethylhexanoate. Examples of the metal complex containing lithium include lithium 2-ethylhexanoate. Examples of the metal complex containing manganese include manganese 2-ethylhexanoate. Examples of the metal complex containing copper include copper 2-ethylhexanoate. Examples of the solvent include 2-ethylhexanoic acid, decane, and a mixed solvent thereof.

In the precursor solution, the molar ratio of potassium to sodium is, for example, 0.7 or more and 1.3 or less, preferably 0.8 or more and 1.2 or less, and more preferably 0.9 or more and 1.1 or less.

Then, the precursor solution thus prepared is applied onto the orientation control layer 30 using a spin coating method or the like to form a precursor layer. Then, the precursor layer is heated at a temperature of, for example, 150 °C or higher and 280 °C or lower and is dried for a certain period of time, and the precursor layer thus dried is further heated at a temperature of, for example, 300 °C or higher and 450 °C or lower and is held for a certain period of time to thereby be degreased. Then, the precursor layer thus degreased is held at a first temperature of 400 °C or more and 500 °C or less for a predetermined time, then the temperature is increased to a second temperature of 600 °C or more and 800 °C or less at a predetermined rate of temperature rise, and the precursor layer is crystallized by holding the precursor layer at the second temperature for a predetermined time. The holding time at the first temperature is, for example, 0.5 minute or more and 3 minutes or less. The rate of temperature rise from the first temperature to the second temperature is, for example, 5 °C/sec or more and 40 °C/sec or less, and preferably 7 °C/sec or more and 20 °C/sec or less. The holding time at the second temperature is, for example, 1 minute or more and 5 minutes or less.

In this way, the crystal layer 42 formed of the KNN layer containing the additive can be formed. Then, the series of processes from the application of the precursor solution to the firing of the precursor layer described above are repeated a plurality of times. Accordingly, the piezoelectric layer 40 including a plurality of crystal layers 42 can be formed.

In the process of forming the piezoelectric layer 40, a heating apparatus used for drying and degreasing the precursor layer is, for example, a hot plate. A heating apparatus used for firing the precursor layer is, for example, an infrared lamp annealing apparatus.

Then, the piezoelectric layer 40 and the orientation control layer 30 are patterned by, for example, photolithography and etching. Then, the second electrode 50 is formed on the piezoelectric layer 40 and the substrate 10. The second electrode 50 is formed by, for example, a sputtering method or a vacuum deposition method.

The piezoelectric element 100 can be manufactured in the steps described above.

### 3. Liquid Ejection Head

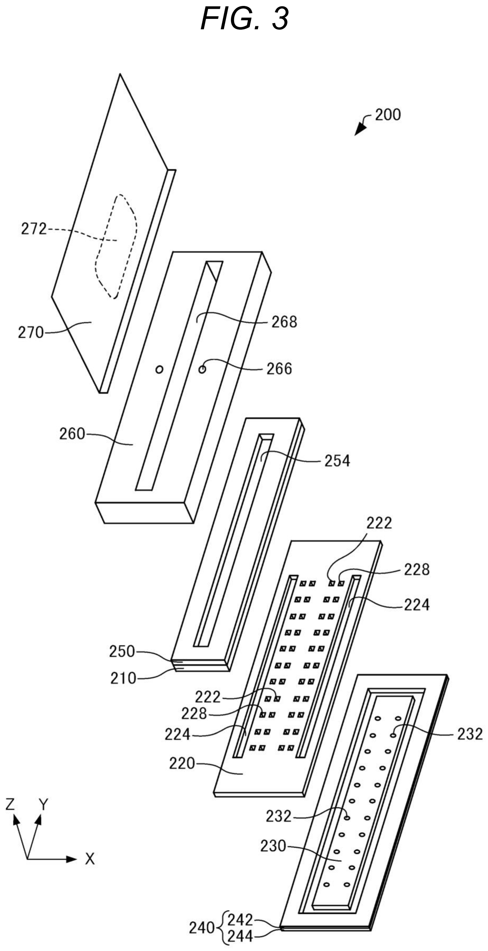

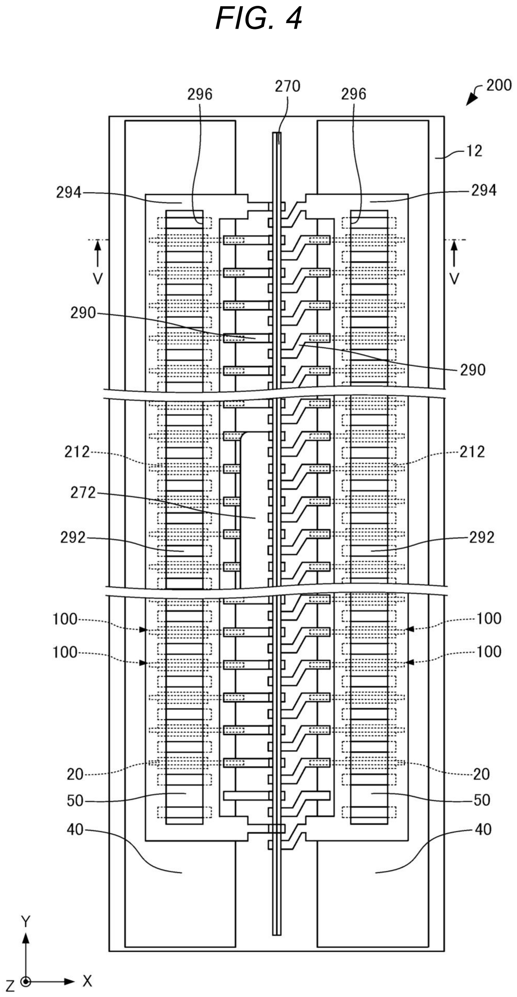

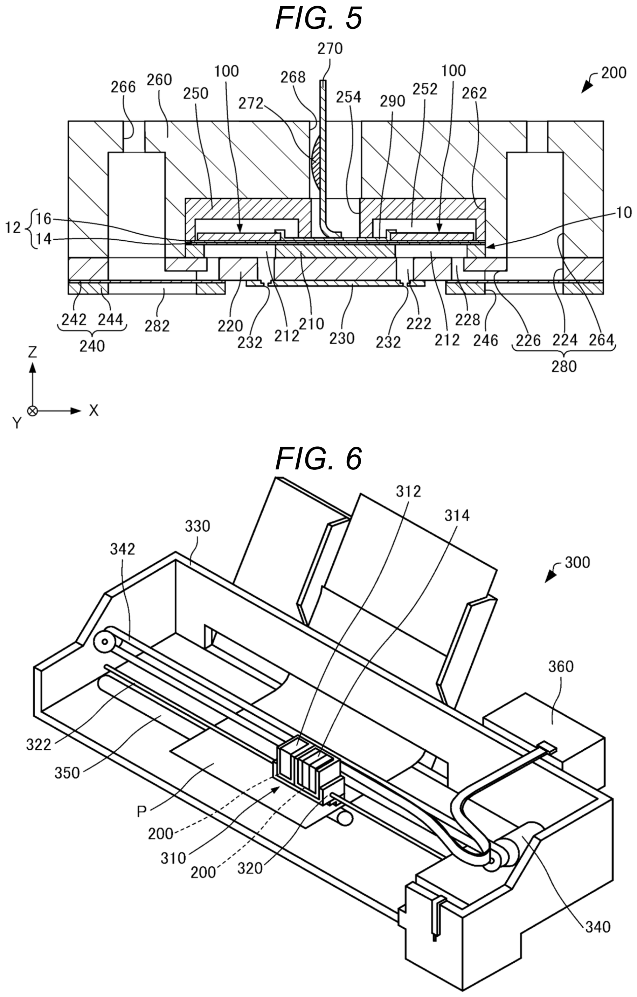

Then, a liquid ejection head according to the present embodiment will be described with reference to the drawings. FIG. 3 is an exploded perspective view schematically showing a liquid ejection head 200 according to the present embodiment. FIG. 4 is a plan view schematically showing the liquid ejection head 200 according to the present embodiment. FIG. 5 is a cross-sectional view along the line V-V shown in FIG. 4, schematically showing the liquid ejection head 200 according to the present embodiment. Note that FIGS. 3 to 5 illustrate an X axis, a Y axis, and a Z axis as three axes orthogonal to each other.

As illustrated in FIGS. 3 to 5, the liquid ejection head 200 includes, for example, a pressure chamber substrate 210, a communication plate 220, a nozzle plate 230, a compliance substrate 240, a protective substrate 250, a case member 260, and a wiring board 270. Note that for the sake of convenience, in FIG. 4, the communication plate 220, the nozzle plate 230, the compliance substrate 240, the protective substrate 250, and the case member 260 are not illustrated.

As illustrated in FIG. 3, the pressure chamber substrate 210 is disposed between the communication plate 220 and the protective substrate 250. As illustrated in FIGS. 4 and 5, a plurality of pressure chambers 212 are provided to the pressure chamber substrate 210. In the example illustrated in FIG. 4, the plurality of pressure chambers 212 are arranged side by side in the Y-axis direction, and two arrays of the pressure chambers 212 arranged side by side in the Y-axis direction are arranged in the X-axis direction. Note that the arrangement of the plurality of pressure chambers 212 is not particularly limited.

A planar shape of the pressure chamber 212 provided to the pressure chamber substrate 210 is a rectangle longer in the X-axis direction than in the Y-axis direction. Note that the planar shape of the pressure chamber 212 is not particularly limited, and may be a parallelogram, a polygon, a circle, an oval shape, or the like. The oval shape refers to a shape formed by providing semicircular shapes to both end portions in the longitudinal direction based on a rectangular shape, and includes a rounded rectangular shape, an elliptical shape, an egg shape, or the like. As the pressure chamber substrate 210, for example, a silicon substrate, a glass substrate, a silicon on insulator (SOI) substrate, or a ceramic substrate is used.

As illustrated in FIG. 3, the communication plate 220 is disposed at the -Z-axis direction side of the pressure chamber substrate 210. The communication plate 220 is disposed between the pressure chamber substrate 210 and the nozzle plate 230. Nozzle communication paths 222 each communicating the pressure chamber 212 and a nozzle 232 with each other are provided to the communication plate 220.

As illustrated in FIG. 5, a first manifold portion 224 and a second manifold portion 226 constituting a part of a manifold 280 are provided to the communication plate 220. The manifold 280 forms a common liquid chamber communicating with the plurality of pressure chambers 212. The first manifold portion 224 penetrates the communication plate 220 in the Z-axis direction. The second manifold portion 226 opens in the -Z-axis direction without penetrating the communication plate 220 in the Z-axis direction. The communication plate 220 is further provided with supply communication paths 228 each communicating with one end portion in the X-axis direction of the pressure chamber 212. The supply communication path 228 communicates the second manifold portion 226 with each of the pressure chambers 212. The supply communication path 228 supplies the ink in the manifold 280 to the pressure chamber 212.

As the communication plate 220, for example, a silicon substrate, a glass substrate, an SOI substrate, a ceramic substrate, or a metal substrate such as a stainless steel substrate is used. A difference between the thermal expansion coefficient of the communication plate 220 and the thermal expansion coefficient of the pressure chamber substrate 210 is preferably small. As a result, even when the temperature of the communication plate 220 and the pressure chamber substrate 210 changes, it is possible to reduce warpage generated in the communication plate 220 and the pressure chamber substrate 210 due to the difference in thermal expansion coefficient.

As illustrated in FIG. 3, the nozzle plate 230 is disposed at the -Z-axis direction side of the communication plate 220. The nozzle plate 230 is provided with the nozzles 232 communicating with the pressure chambers 212 via the nozzle communication paths 222, respectively. A plurality of nozzles 232 are formed. In the illustrated example, the plurality of nozzles 232 are arranged side by side in the Y-axis direction, and the two arrays of the nozzles 232 arranged in the Y-axis direction are arranged in the X-axis direction. Note that the arrangement of the nozzles 232 is not particularly limited.

As the nozzle plate 230, for example, a silicon substrate, a glass substrate, an SOI substrate, a ceramic substrate, or a metal substrate such as a stainless steel substrate is used. Note that the material of the nozzle plate 230 may be an organic substance such as polyimide resin. A difference between the thermal expansion coefficient of the nozzle plate 230 and the thermal expansion coefficient of the communication plate 220 is preferably small. As a result, even when the temperature of the nozzle plate 230 and the communication plate 220 changes, it is possible to reduce warpage generated in the nozzle plate 230 and the communication plate 220 due to the difference in thermal expansion coefficient.

The compliance substrate 240 is disposed at the -Z-axis direction side of the communication plate 220. The compliance substrate 240 surrounds the nozzle plate 230 when viewed from the Z-axis direction. As illustrated in FIG. 5, the compliance substrate 240 seals openings of the first manifold portions 224 and the second manifold portions 226 provided to the communication plate 220. The compliance substrate 240 includes, for example, a sealing film 242 formed of a thin film having flexibility and a fixation substrate 244 formed of a hard material such as metal. Opening portions 246 penetrating in the Z-axis direction are formed in portions opposed to the manifolds 280 of the fixation substrate 244. Due to the opening portion 246, a surface at one side of the manifold 280 forms a compliance portion 282 sealed only by the sealing film 242 having flexibility.

As illustrated in FIG. 3, the protective substrate 250 is disposed at the +Z-axis direction side of the pressure chamber substrate 210. The protective substrate 250 is disposed between the pressure chamber substrate 210 and the case member 260. The protective substrate 250 is bonded to the pressure chamber substrate 210 with an adhesive or the like. As shown in FIG. 5, the protective substrates 250 are provided with holding portions 252 which are spaces for protecting the piezoelectric elements 100. A plurality of holding portions 252 are formed so as to correspond to the plurality of piezoelectric elements 100. A through hole 254 penetrating the protective substrate 250 in the Z-axis direction is formed between the holding portions 252 adjacent to each other in the X-axis direction.

The case member 260 is disposed at the +Z-axis direction side of the protective substrate 250. The case member 260 defines the manifolds 280 communicating with the plurality of pressure chambers 212 together with the pressure chamber substrate 210. The case member 260 has, for example, substantially the same shape as the shape of the communication plate 220 when viewed from the Z-axis direction. The case member 260 is bonded to the protective substrate 250 and the communication plate 220.

The case member 260 is provided with a housing portion 262 that houses the pressure chamber substrate 210 and the communication plate 220 and is formed at the protective substrate 250 side. The communication plate 220 is disposed in an opening at the nozzle plate 230 side of the housing portion 262 in a state where the pressure chamber substrate 210 and the communication plate 220 are housed in the housing portion 262.

In the case member 260, third manifold portions 264 are respectively formed at both outer sides of the housing portion 262 in the X-axis direction. The manifold 280 is configured with the first manifold portion 224 and the second manifold portion 226 provided to the communication plate 220, and the third manifold portion 264 provided to the case member 260. The manifold 280 is formed continuously throughout the entire length in the Y-axis direction.

Supply ports 266 for supplying the ink to the manifolds 280 are provided to the case member 260. The case member 260 is further provided with a through hole 268 communicating with the through hole 254 provided to the protective substrate 250.

The wiring board 270 is inserted into the through hole 268 provided to the case member 260 and the through hole 254 provided to the protective substrate 250. The wiring board 270 includes an integrated circuit 272 for driving the piezoelectric elements 100. The wiring board 270 includes, for example, a flexible printed circuit (FPC) or a flexible flat cable (FFC).

As illustrated in FIGS. 4 and 5, the liquid ejection head 200 includes, for example, the piezoelectric elements 100. For example, the plurality of piezoelectric elements 100 are provided. In the example illustrated in FIG. 4, the plurality of piezoelectric elements 100 are arranged side by side in the Y-axis direction, and the two arrays of the piezoelectric elements 100 arranged in the Y-axis direction are arranged in the X-axis direction. Note that the arrangement of the piezoelectric elements 100 is not particularly limited. Further, in FIGS. 4 and 5, for the sake of convenience, the piezoelectric elements 100 are illustrated in a simplified manner.

The substrate 10 is common to the plurality of piezoelectric elements 100. In the plurality of piezoelectric elements 100, the substrate 10 constitutes a common substrate. As illustrated in FIG. 5, the substrate 10 includes, for example, a vibrating plate 12 and the pressure chamber substrate 210. The vibrating plate 12 includes, for example, a silicon oxide layer 14 and a zirconium oxide layer 16 disposed on the silicon oxide layer 14.

In the plurality of piezoelectric elements 100, for example, the first electrodes 20 are separated from each other. In the plurality of piezoelectric elements 100, the first electrodes 20 constitute individual electrodes. That is, the first electrodes 20 are individually provided for the plurality of pressure chambers 212. As illustrated in FIG. 4, the first electrodes 20 are each provided with a width narrower than the width of the pressure chamber 212 in the Y-axis direction.

Individual lead electrodes 290 are electrically coupled to the first electrodes 20, respectively. As shown in FIG. 5, the individual lead electrodes 290 each extend into the through hole 254 provided to the protective substrate 250. In the through hole 254, the individual lead electrodes 290 are electrically coupled to the wiring board 270. A material of the individual lead electrodes 290 is metal such as copper or gold.

In the plurality of piezoelectric elements 100, as illustrated in FIG. 4, the piezoelectric layer 40 has a shape extending in the X-axis direction, and is continuous between the piezoelectric elements 100 adjacent in the Y-axis direction to each other at both ends in the X-axis direction. In the illustrated example, a groove portion 292 is formed between the piezoelectric layers 40 adjacent to each other in the Y-axis direction. The groove portion 292 does not overlap the first electrode 20 when viewed from the Z-axis direction. In the groove portion 292, the piezoelectric layer 40 may be completely removed or may be formed to be thinner than other portions. The vibrating plates 12 can be more favorably displaced due to the groove portions 292.

The second electrode 50 is common to the plurality of piezoelectric elements 100. The second electrode 50 constitutes a common electrode in the plurality of piezoelectric elements 100. That is, the second electrode 50 is provided in common to the plurality of pressure chambers 212 arranged in the Y-axis direction.

A common lead electrode 294 is electrically coupled to the second electrode 50. The common lead electrode 294 is disposed on, for example, the second electrode 50. In the example shown in FIG. 4, the common lead electrode 294 has a frame shape provided with an opening 296. Due to the opening 296, suppression of deformation of the piezoelectric layer 40 by the common lead electrode 294 can be reduced. The common lead electrode 294 extends into the through hole 254 provided to the protective substrate 250. In the through hole 254, the common lead electrode 294 is electrically coupled to the wiring board 270. A material of the common lead electrode 294 is metal such as copper or gold.

In the liquid ejection head 200, signals are supplied from the integrated circuit 272 to the first electrodes 20, and a signal at a reference potential is supplied to the second electrode 50. Accordingly, a potential difference is generated between the first electrode 20 and the second electrode 50, and the piezoelectric layer 40 is deformed by that potential difference. Due to the deformation of the piezoelectric layer 40, the vibrating plate 12 is deformed to change the volume of the pressure chamber 212. Then, a change in pressure caused by the change in volume of the pressure chamber 212 is applied to the ink stored in the pressure chamber 212. As a result, the ink stored in the pressure chamber 212 is ejected from the nozzle 232 via the nozzle communication path 222.

### 4. Liquid Ejection Apparatus

Then, a liquid ejection apparatus according to the present embodiment will be described with reference to the drawings. FIG. 6 is a perspective view schematically illustrating a liquid ejection apparatus 300 according to the present embodiment.

As illustrated in, for example, FIG. 6, the liquid ejection apparatus 300 includes a head unit 310, a carriage 320, a carriage shaft 322, an apparatus main body 330, a drive motor 340, a timing belt 342, a conveyance roller 350, and a printer controller 360. The liquid ejection apparatus 300 is, for example, an inkjet printer of a serial printing type that ejects ink as a liquid.

The head unit 310 includes, for example, the liquid ejection heads 200. The number of liquid ejection heads 200 is not particularly limited. Cartridges 312, 314 which constitute a liquid supply unit are detachably attached to the head unit 310. The liquid ejection heads 200 eject the ink supplied from the cartridges 312, 314.

The head unit 310 is mounted on the carriage 320. The carriage 320 is disposed movably in the axial direction on the carriage shaft 322 attached to the apparatus main body 330. In the liquid ejection apparatus 300, the carriage 320 reciprocates along the carriage shaft 322, and ejects the ink from the liquid ejection heads 200 onto a recording target medium P conveyed along the conveyance direction to thereby form a desired image on the recording target medium P. As the recording target medium P, any printing target such as printing sheet, a resin film, or fabric is used. In the illustrated example, the recording target medium P is a printing sheet.

The drive motor 340 is provided to the apparatus main body 330. Drive force of the drive motor 340 is transferred to the carriage 320 via a plurality of gears and the timing belt 342 (not illustrated). Accordingly, the carriage 320 is moved along the carriage shaft 322.

The conveyance roller 350 is provided to the apparatus main body 330. The conveyance roller 350 is a conveyance mechanism that relatively moves the recording target medium P with respect to the liquid ejection heads 200. The conveyance mechanism that conveys the recording target medium P is not limited to the conveyance roller, but may be a belt, a drum, or the like.

The printer controller 360 is a controller that controls the liquid ejection heads 200 and the drive motor 340. The printer controller 360 is electrically coupled to the integrated circuits 272 of the liquid ejection heads 200. The printer controller 360 includes, for example, a random access memory (RAM) that temporarily stores various types of data, a read only memory (ROM) that stores control programs and the so on, a central processing unit (CPU), and a drive signal generation circuit that generates drive signals to be supplied to the liquid ejection heads 200.

Note that the liquid ejection apparatus according to the present disclosure is not limited to the inkjet printer of the serial printing type, but may be an inkjet printer of a line printing type. Further, the liquid ejection apparatus according to the present disclosure is not limited to an inkjet printer, and may be a color material ejection apparatus used for manufacture of a color filter for a liquid crystal display or the like, an electrode material ejection apparatus used for formation of an electrode for an organic EL display, a field emission display (FED), or the like, a bioorganic material ejection apparatus used for manufacture of a biochip, a three-dimensional modeling apparatus, a textile printing apparatus, or the like.

In addition, the piezoelectric element according to the present disclosure is not limited to a liquid ejection head and a printer, and can be used for a wide range of applications. The piezoelectric element according to the present disclosure is preferably used as a piezoelectric actuator of, for example, an ultrasonic motor, a vibrating dust removal device, a piezoelectric transformer, a piezoelectric speaker, a piezoelectric pump, and a pressure-electricity conversion device. Further, the piezoelectric element according to the present disclosure is preferably used as a piezoelectric-type sensor element of, for example, an ultrasonic detector, an angular velocity sensor, an acceleration sensor, a vibration sensor, a tilt sensor, a pressure sensor, a collision sensor, a human sensor, an infrared sensor, a terahertz sensor, a heat detection sensor, a pyroelectric sensor, and a piezoelectric sensor. Further, the piezoelectric element according to the present disclosure is preferably used as a ferroelectric element such as a ferroelectric memory (FeRAM), a ferroelectric transistor (FeFET), a ferroelectric calculation circuit (FeLogic), and a ferroelectric capacitor. In addition, the piezoelectric element according to the present disclosure is preferably used as a voltage-controlled optical element of a wavelength converter, an optical waveguide, an optical path modulator, a refractive index control element, an electronic shutter mechanism, and so on.

### 5. Practical Examples and Comparative Examples

### 5.1. Preparation of Samples

### 5.1.1. Practical Example 1

A silicon oxide layer having a thickness of 1460 nm was formed by thermally oxidizing a surface of a single crystal silicon substrate. Then, a zirconium layer having a thickness of 400 nm was formed by a direct current (DC) sputtering method, and then a zirconium oxide layer was formed by a heat treatment at 850 °C.

Then, a titanium layer having a thickness of 20 nm, a platinum layer having a thickness of 80 nm, and an iridium layer having a thickness of 5 nm were formed on the zirconium oxide layer by a DC sputtering method to form the first electrode.

Then, a BFTP precursor solution was prepared so as to have a molar ratio of Bi:Pb:Fe:Ti=110:10:50:50. Then, the BFTP precursor solution thus prepared was applied onto the first electrode by a spin coating method, dried at 180 °C for 3 minutes, degreased at 380 °C for 3 minutes, and fired at 650 °C for 3 minutes. In this way, the BFTP layer having a thickness of 20 nm was formed as the orientation control layer.

Then, the piezoelectric layer was formed by a sol-gel method. Specifically, simple solutions respectively containing potassium 2-ethylhexanoate, sodium 2-ethylhexanoate, and niobium 2-ethylhexanoate were each synthesized. These simple solutions were mixed to obtain (K_{0.50}Na_{0.50})_{1.015}NbO₃ to thereby obtain a KNN precursor solution.

Then, the KNN precursor solution thus prepared was applied onto the BFTP layer by a spin coating method, dried at 240 °C for 3 minutes, and degreased at 380°C for 3 minutes to form a KNN precursor layer. After the temperature was once returned to room temperature, the KNN precursor layer was held at 450 °C for 1 minute, then the temperature was raised to 700 °C at a rate of temperature rise of 10 °C/sec, and held at 700 °C for 3 minutes to thereby form a crystal layer having a thickness of 100 nm. Then, by repeating the series of steps from the application of the KNN precursor solution to the firing of the KNN precursor layer, the piezoelectric layer configured with a plurality of crystal layers was formed.

Then, a platinum layer having a thickness of 50 nm was formed on the piezoelectric layer by a DC sputtering method to form the second electrode. Then, the second electrode was patterned by photolithography and etching.

In this way, a sample in Practical Example 1 was prepared.

### 5.1.2. Practical Example 2

A sample in Practical Example 2 was produced in substantially the same method as in Practical Example 1 described above except that the rate of temperature rise in firing was set to 40 °C/sec instead of 10 °C/sec.

### 5.1.3. Practical Example 3

As a precursor solution for forming the piezoelectric layer, a KNN precursor solution containing lithium, manganese, and copper as additives was used. Specifically, in addition to the simple solutions used in Practical Example 1 described above, simple solutions respectively containing lithium 2-ethylhexanoate, manganese 2-ethylhexanoate, and copper 2-ethylhexanoate were used. These simple solutions were mixed so as to obtain (K_{0.465}Na_{0.465}Li_{0.07})_{1.015}(Nb_{0.984}Mn_{0.01}Cu_{0.006})O₃ to thereby obtain a KNN precursor solution containing lithium, manganese, and copper. Further, the number of crystal layers was changed.

The sample in Practical Example 3 was produced in substantially the same method as in Practical Example 1 described above except the above.

### 5.1.4. Comparative Example 1

A piezoelectric element including a piezoelectric layer formed of the KNN layer formed by a sputtering method and the first electrode and the second electrode sandwiching the piezoelectric layer was used as a sample in Comparative Example 1.

### 5.2. Evaluation Method

In Practical Examples 1 to 3 and Comparative Example 1, the SIMS analysis was performed in the depth direction from the surface of the piezoelectric layer to the first electrode. As a measurement apparatus, "IMS-7f" manufactured by CAMECA was used. A surface of the sample was irradiated with Cs⁺ having acceleration energy of 15 keV and a current amount of 10 nA as a primary ion beam to detect negative secondary ions. In the measurement, a high mass decomposition mode was set for the purpose of removing an influence of interfering ions, and an Au coating film was formed on the surface of the sample for the purpose of preventing charge-up that may occur during the insulator measurement, and electron beam irradiation was performed.

### 5.3. Evaluation Result

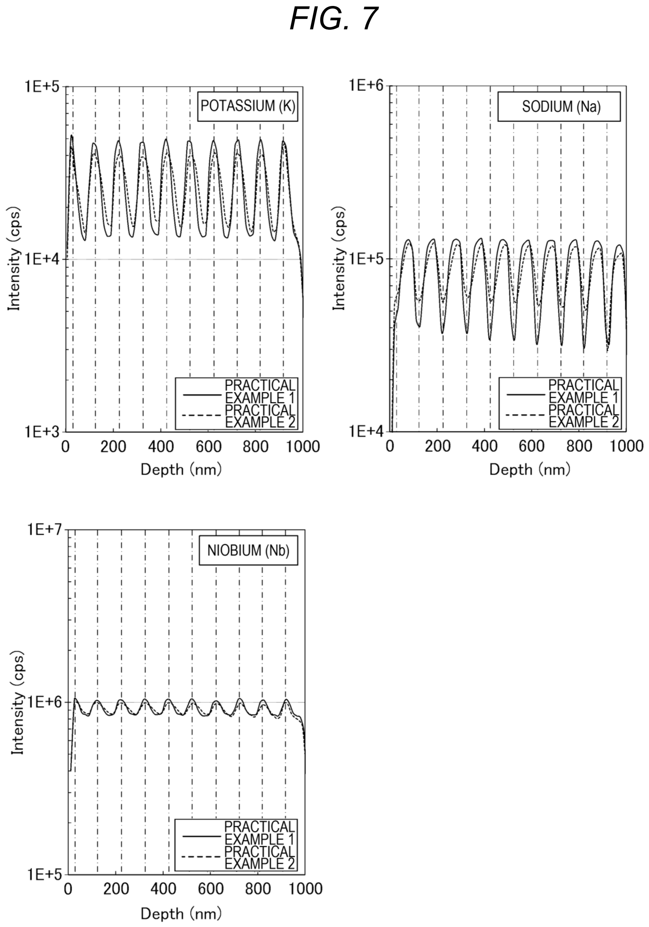

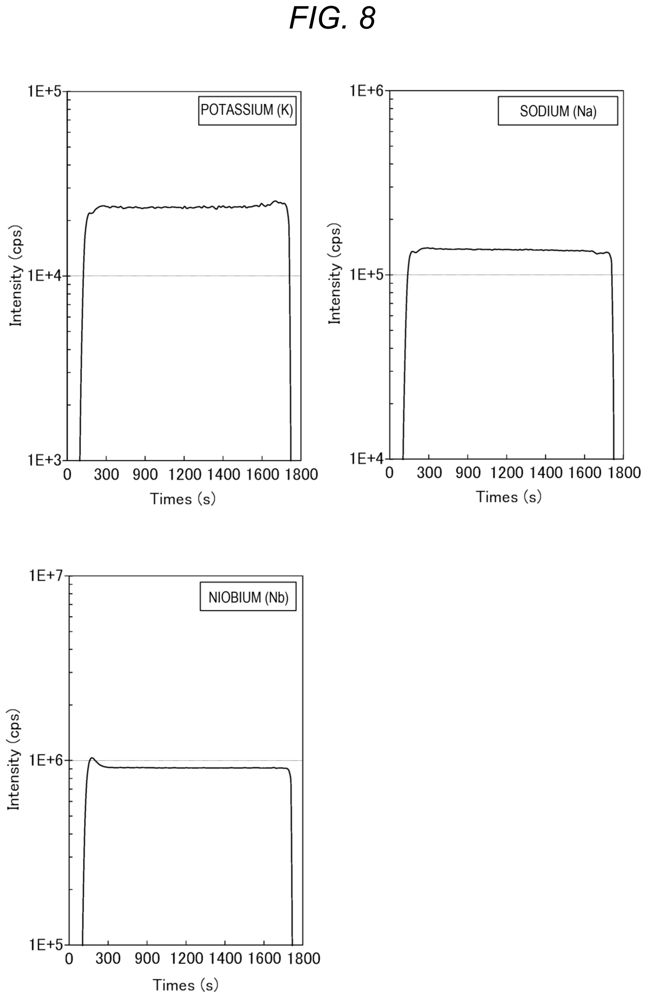

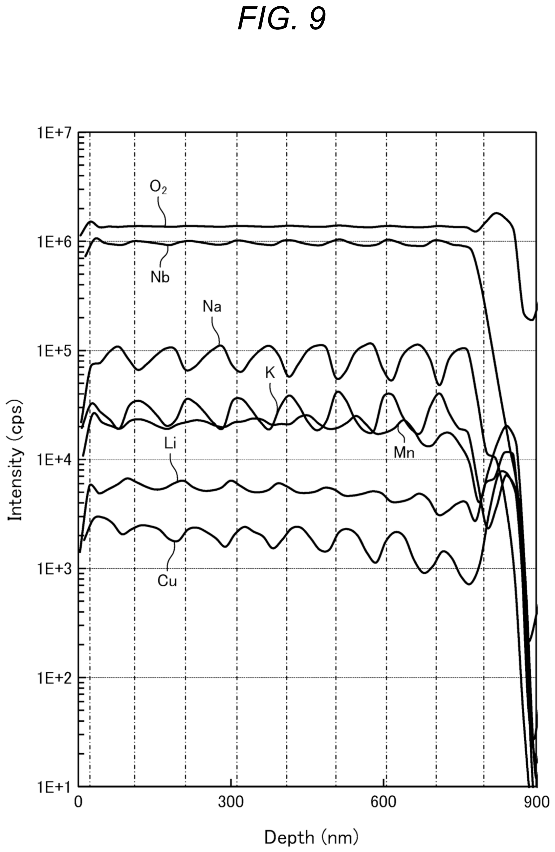

FIG. 7 is a diagram showing graphs representing results of the SIMS analysis in Practical Examples 1 and 2. FIG. 8 is a diagram showing graphs representing a result of the SIMS analysis in Comparative Example 1. FIG. 9 is a diagram showing a graph representing a result of the SIMS analysis in Practical Example 3.

Note that FIGS. 7 and 8 show the results with respect to potassium (K), sodium (Na), and niobium (Nb). In FIG. 7, Practical Example 1 is represented by a solid line, and Practical Example 2 is represented by a chain line. FIG. 9 shows the results with respect to potassium (K), sodium (Na), niobium (Nb), lithium (Li), manganese (Mn), copper (Cu), and oxygen (O₂). FIGS. 7 to 9 show intensities normalized by oxygen. In FIGS. 7 and 9, the positions of the interfaces between adjacent crystal layers are indicated by dashed-dotted lines. In FIGS. 7 and 9, the horizontal axis represents the depth from the surface of the piezoelectric layer. In FIG. 8, the horizontal axis represents etching time corresponding to the depth from the surface of the piezoelectric layer.

In Practical Examples 1, 2, as shown in FIG. 7, the intensity attributed to potassium was high and the intensity attributed to sodium was low at the positions of the interfaces between adjacent crystal layers (hereinafter, also referred to as "interface positions"). Accordingly, it was found out that the atomic concentration (at%) of potassium was higher than the atomic concentration (at%) of sodium at the interface positions. At intermediate positions (hereinafter, also referred to as "intermediate positions") between the interfaces between the adjacent crystal layers, the intensity attributed to potassium was low, and the intensity attributed to sodium was high. Accordingly, it was found out that the atomic concentration (at%) of potassium was lower than the atomic concentration (at%) of sodium at the intermediate positions.

From the above, it was found out that the K/Na molar ratio at the interface positions was higher than the K/Na molar ratio at the intermediate positions. As described above, in Practical Examples 1, 2, the composition gradients of potassium and sodium were observed in the depth direction of the piezoelectric layer.

In Practical Example 1 in which the rate of temperature rise in firing was low, the intensity attributed to potassium was higher and the intensity attributed to sodium was lower at the interface positions than in Practical Example 2 in which the rate of temperature rise in firing was high. Furthermore, in Practical Example 1, the intensity attributed to sodium was higher and the intensity attributed to potassium was lower at the intermediate positions than in Practical Example 2. Thus, it was found out that when the rate of temperature rise in firing was reduced, the composition gradients of potassium and sodium were increased in the depth direction of the piezoelectric layer.

Similarly to potassium, niobium had a high atomic concentration (at%) at the interface positions and a low atomic concentration (at%) at the intermediate positions. However, the composition gradient of niobium was smaller than the composition gradients of potassium and sodium.

On the other hand, in Comparative Example 1, as shown in FIG. 8, the composition gradients of potassium, sodium, and niobium as in Practical Examples 1, 2 were not observed.

In Practical Example 3, as shown in FIG. 9, composition gradients of potassium, sodium, and niobium were observed similarly to Practical Examples 1, 2. Similarly to sodium, lithium had a low atomic concentration (at%) at the interface positions and a high atomic concentration (at%) at the intermediate positions. Similarly to potassium, manganese and copper had a high atomic concentration (at%) at the interface positions and a low atomic concentration (at%) at the intermediate positions.

When the leakage currents in Practical Examples 1 to 3 and Comparative Example 1 were measured, in Practical Examples 1 to 3 in which the composition gradients of potassium and sodium were observed in the depth direction of the piezoelectric layer, the leakage currents were small and the insulation property was high compared to Comparative Example 1 in which the composition gradients of potassium and sodium were not observed. Accordingly, it was found out that when the K/Na molar ratio at the interface positions is larger than the K/Na molar ratio at the intermediate positions, the insulation property of the piezoelectric layer can be improved.

Further, in Practical Examples 1, 3 in which the rate of temperature rise in firing was low, the leakage currents were small and the insulation property was high compared to Practical Example 2 in which the rate of temperature rise in firing was high. When the rate of temperature rise in firing is low, a time difference between crystallization of sodium niobate and crystallization of potassium niobate becomes large, and thus a region of potassium niobate having a higher insulation property clearly appears. Therefore, it is considered that the leakage current was smaller in Practical Examples 1, 3 in which the rate of temperature rise in firing was low than in Practical Example 2 in which the rate of temperature rise in firing was high.

The embodiments and the modified examples described above are illustrative only, and the present disclosure is not limited thereto. For example, it is possible to appropriately combine the embodiments and the modified examples with each other.

The present disclosure includes substantially the same configurations as the configurations described in the embodiment, such as configurations having the same functions, methods, and results, or configurations having the same objects and advantages. Further, the present disclosure includes configurations obtained by replacing non-essential portions of the configurations described in the embodiment. Furthermore, the present disclosure includes configurations that exert the same functions and advantages or configurations that can achieve the same objects as those of the configurations described in the embodiments. Further, the present disclosure includes a configuration obtained by adding a known technique to the configurations described in the embodiments.

The following configurations are derived from the embodiments and modified examples described above.

An aspect of a piezoelectric element includes
a substrate,
a first electrode disposed on the substrate,
a piezoelectric layer disposed on the first electrode and containing potassium, sodium, and niobium, and
a second electrode disposed on the piezoelectric layer, wherein
the piezoelectric layer includes
a first layer disposed on the first electrode, and
a second layer disposed on the first layer,
the piezoelectric layer includes
a first region including a first interface between the first layer and the second layer, and
a second region located inside the first layer without including the first interface, and
a molar ratio of potassium to sodium in the first region is higher than the molar ratio in the second region.

According to the present piezoelectric element, the insulation property of the piezoelectric layer can be improved.

In the aspect of the piezoelectric element,
an atomic concentration (at%) of potassium may be higher than an atomic concentration (at%) of sodium in the first region, and
an atomic concentration (at%) of potassium may be lower than an atomic concentration (at%) of sodium in the second region.

According to the present piezoelectric element, the crystal growth in the piezoelectric layer can be promoted, and the insulation property of the piezoelectric layer can be improved.

In the aspect of the piezoelectric element,
the piezoelectric layer may include a third layer disposed on the second layer,
the piezoelectric layer may include
a third region including a second interface between the second layer and the third layer, and
a fourth region located inside the second layer without including the second interface, and
the molar ratio in the third region may be higher than the molar ratio in the fourth region.

According to the present piezoelectric element, the insulation property of the piezoelectric layer can be further improved by the third region.

In the aspect of the piezoelectric element,
an atomic concentration (at%) of niobium in the first region may be higher than an atomic concentration (at%) of niobium in the second region.

According to the present piezoelectric element, defects of niobium in the first region can be reduced.

In the aspect of the piezoelectric element,
a difference between an atomic concentration (at%) of niobium in the first region and an atomic concentration (at%) of niobium in the second region may be smaller than a difference between an atomic concentration (at%) of potassium in the first region and an atomic concentration (at%) of potassium in the second region and a difference between an atomic concentration (at%) of sodium in the first region and an atomic concentration (at%) of sodium in the second region.

According to the present piezoelectric element, it is possible to reduce the defects of niobium in the entire piezoelectric layer in the thickness direction.

In the aspect of the piezoelectric element,
the piezoelectric layer may contain manganese, and
an atomic concentration (at%) of manganese in the first region may be higher than an atomic concentration (at%) of manganese in the second region.

According to the present piezoelectric element, stress generated in the piezoelectric layer can be reduced.

In the aspect of the piezoelectric element,
the piezoelectric layer may contain copper, and
an atomic concentration (at%) of copper in the first region may be higher than an atomic concentration (at%) of copper in the second region.

According to the present piezoelectric element, stress generated in the piezoelectric layer can be reduced.

In the aspect of the piezoelectric element,
the piezoelectric layer may contain lithium, and
an atomic concentration (at%) of lithium in the second region may be higher than an atomic concentration (at%) of lithium in the first region.

According to the present piezoelectric element, the crystal growth in the piezoelectric layer can be promoted.

In the aspect of the piezoelectric element, there may further be provided
an orientation control layer disposed between the first electrode and the piezoelectric layer and containing bismuth, iron, titanium, and lead, wherein
the second region may be located between the orientation control layer and the first region.

According to the present piezoelectric element, stress generated in the piezoelectric layer can be reduced.

An aspect of a liquid ejection head includes
the aspect of the piezoelectric element.

An aspect of the liquid ejection apparatus includes
the liquid ejection head.

## Claims

1. A piezoelectric element comprising:
a substrate;
a first electrode disposed on the substrate;
a piezoelectric layer disposed on the first electrode and containing potassium, sodium, and niobium; and
a second electrode disposed on the piezoelectric layer, wherein
the piezoelectric layer includes
a first layer disposed on the first electrode, and
a second layer disposed on the first layer,
the piezoelectric layer includes
a first region including a first interface between the first layer and the second layer, and
a second region located inside the first layer without including the first interface, and
a molar ratio of potassium to sodium in the first region is higher than the molar ratio in the second region.

2. The piezoelectric element according to claim 1, wherein
an atomic concentration (at%) of potassium is higher than an atomic concentration (at%) of sodium in the first region, and
an atomic concentration (at%) of potassium is lower than an atomic concentration (at%) of sodium in the second region.

3. The piezoelectric element according to claim 1, wherein
the piezoelectric layer includes a third layer disposed on the second layer,
the piezoelectric layer includes
a third region including a second interface between the second layer and the third layer,
and
a fourth region located inside the second layer without including the second interface,
and
the molar ratio in the third region is higher than the molar ratio in the fourth region.

4. The piezoelectric element according to claim 1, wherein
an atomic concentration (at%) of niobium in the first region is higher than an atomic concentration (at%) of niobium in the second region.

5. The piezoelectric element according to claim 1, wherein
a difference between an atomic concentration (at%) of niobium in the first region and an atomic concentration (at%) of niobium in the second region is smaller than a difference between an atomic concentration (at%) of potassium in the first region and an atomic concentration (at%) of potassium in the second region and a difference between an atomic concentration (at%) of sodium in the first region and an atomic concentration (at%) of sodium in the second region.

6. The piezoelectric element according to claim 1, wherein
the piezoelectric layer contains manganese, and
an atomic concentration (at%) of manganese in the first region is higher than an atomic concentration (at%) of manganese in the second region.

7. The piezoelectric element according to claim 1, wherein
the piezoelectric layer contains copper, and
an atomic concentration (at%) of copper in the first region is higher than an atomic concentration (at%) of copper in the second region.

8. The piezoelectric element according to claim 1, wherein
the piezoelectric layer contains lithium, and
an atomic concentration (at%) of lithium in the second region is higher than an atomic concentration (at%) of lithium in the first region.

9. The piezoelectric element according to claim 1, comprising
an orientation control layer disposed between the first electrode and the piezoelectric layer and containing bismuth, iron, titanium, and lead, wherein
the second region is located between the orientation control layer and the first region.

10. A liquid ejection head comprising
the piezoelectric element according to claim 1.

11. A liquid ejection apparatus comprising
the liquid ejection head according to claim 10.
